# EUROPÄISCHE PATENTSCHRIFT

(11) **EP 1 002 844 B1**
(45) Veröffentlichungstag und Bekanntmachung des Hinweises auf die Patenterteilung: **07.01.2004**
(21) Anmeldenummer: 99119499.4
(22) Anmeldetag: 01.10.1999
(51) Int. Cl.: C09J 7/00, H01L 21/60, H01L 23/498, H01R 4/04, H01R 13/03, H05K 3/32

(54) **Elektrisch leitfähige, thermoplastische und hitzeaktivierbare Klebstofffolie**
Electroconductive, thermoplastic and heat-activatable adhesive film
Film adhésif électroconducteur, thermoplastique et thermo-activable

(30) Priorität: 21.11.1998 DE 19853805
(43) Veröffentlichungstag der Anmeldung: 24.05.2000
(73) Patentinhaber: Tesa AG, 20253 Hamburg (DE)
(72) Erfinder: Pfaff, Ronald, Dr., 22335 Hamburg (DE)

(56) Entgegenhaltungen:
- EP-A- 0 134 623
- EP-A- 0 140 619
- EP-A- 0 846 743
- WO-A-98/03047
- PATENT ABSTRACTS OF JAPAN vol. 018, no. 527 (E-1613), 5. Oktober 1994 (1994-10-05) & JP 06 187834 A (SUMITOMO BAKELITE CO LTD), 8. Juli 1994 (1994-07-08)

## Beschreibung

Die Erfindung beschreibt eine elektrisch leitfähige, thermoplastische und hitzeaktivierbare Klebstoffolie, wie sie zur dauerhaften Verbindung von zwei Gegenständen verwendet wird.

Elektronische Bauteile werden zunehmend kleiner, wodurch ihre Handhabung und Verarbeitung immer weiter erschwert wird. Vor allem beim Herstellen von elektrischen Kontakten zwischen den Bauteilen und/oder den Anschlüssen zeigt sich, daß herkömmliches Löten die entsprechenden Kontakte nicht mehr einfach und kostengünstig verbinden kann.
Die Verklebung elektronischer Bauteile durch elektrisch leitfähige Klebstoffschichten ist eine Alternative.

Für den Bereich der elektrisch leitfähigen Klebebänder ist es bekannt, leitfähige Pigmente wie Ruß, Metallpulver, ionische Verbindung u.ä. in Klebemassen einzusetzen. Bei ausreichenden Mengen berühren sich die Partikel untereinander und die Möglichkeit des Stromflusses von Partikel zu Partikel ist gegeben. Der Stromfluß ist hier nicht richtungsorientiert (isotrop).
Für spezielle Anwendungen wie elektronische Schalter, Kontaktierung von Leitern etc. besteht aber die Forderung, elektrische Leitfähigkeit nur in Dickenrichtung (z-Richtung) durch das Klebeband zu erzielen, dafür aber keine Leitfähigkeit in der flächigen Ausdehnung (x-y-Ebene) der Klebeschicht.

In speziellen Fällen ist ferner sicherzustellen und zu fordern, daß die leitfähigen Stellen durch die Klebeschicht (in z-Richtung)
- homogen verteilt sind, so daß beliebige Stellen des Klebebands
- identisch verwendet und zu gleichen Ergebnissen führen,
- kleine Querschnitte haben, um auch im Bereich der Elektronik eng zusammen liegende Leiterbahnen selektiv ohne Gefahr von Kurzschlüssen verbinden zu können und
- die leitfähigen Stellen untereinander isoliert sind, indem die Zwischenräume mit nicht leitenden Materialien ausgefüllt sind.

Die US 3,475,213 beschreibt statistisch verteilte sphärische Partikel in einer Selbstklebemasse, die ganz aus einem leitfähigen Metall bestehen oder mit einer elektrisch leitfähigen Schicht versehen sind. Die besten Ergebnisse werden mit Partikeln erzielt, die nur wenig kleiner sind, als die Dicke der Klebemasseschicht ist.

Gemäß US 5,300,340 werden durch ein spezielles Herstellverfahren mit einer rotierenden Trommel die elektrisch leitfähigen Partikel in die Klebemasse plaziert, wobei die Partikel geringfügig größer als die Dicke der Klebemasseschicht sind.

Die oben beschriebenen Lösungen setzen zum einen die Verklebungsfestigkeit herab, zum anderen bewirken sie einen Abstand des Klebebands zur Oberfläche, da die Partikel zu einem gewissen Grad aus der Oberfläche herausragen, was nachteilig für die Verklebungsfestigkeit ist, zur Verbesserung der elektrischen Leitfähigkeit jedoch durchaus erwünscht wird.

Die US 4,606,962 behandelt eine Verbesserung des elektrischen Kontakts. Dabei wird beschrieben, daß der Einsatz von weichen, sphärischen Partikeln anstelle von sphärischen, versilberten Glaskugeln dauerhafte elektrisch leitende Kontakte durch die Klebemasseschicht ermöglicht. Dies wird dadurch begründet, daß die weichen Partikel, die nicht härter sind als reines Silber bei der Aktivierungstemperatur des Klebers, sich unter Belastungen an den Kontaktflächen abflachen und so die Kontaktoberfläche vergrößern.

In Versuchen konnte gezeigt werden, daß herausragende Partikel immer zu unerwünschten Lufteinschlüssen in der Klebefuge führen, was die Verbindungsstärke empfindlich herabsetzt und dazu führt, daß die Partikel in einer elastischen Klebefuge bei mechanischen Belastungen den Kontakt verloren, der erst durch erneutes Verpressen wieder hergestellt werden kann.

Vor allem bei elektronischen Geräten, die klein und flexibel sind, wie sie in elektronischem Spielzeug oder Chipkarten verwendet werden, ist die elektrisch leitende Klebeverbindung häufig nicht durch ein starres Gehäuse geschützt und muß Biegebelastungen standhalten, ohne den elektrischen Kontakt zu verlieren.

Die oben vorgestellten Verfahren zeigen also entweder nur unzureichende Verbindungsfestigkeiten für mechanische beanspruchte elektrische Kontakte oder der elektrisch leitende Kontakt kann nicht dauerhaft garantiert werden.

Aus der DE 195 19 499 ist des weiteren eine thermoplastische Klebstoffolie zum Implantieren von elektrischen Modulen in einen Kartenkörper, der mit einer Aussparung versehen ist, in die ein elektronisches Modul anzuordnen ist, das auf der ersten Seite mehrere Kontaktflächen und auf der der ersten Seite gegenüberliegenden zweiten Seite einen IC-Baustein aufweist, dessen Anschlußpunkte über elektrische Leiter mit den Kontaktflächen verbunden sind, wobei die Klebstoffolie zur Verbindung der zweiten Seite des Moduls mit dem Kartenkörper dient. Die Klebstoffolie weist die Kombination folgender Bestandteile auf:
i) ein thermoplastisches Polymer mit einem Anteil von 50 bis 100 Gew.-% und dazu
ii) ein oder mehrere klebrigmachende Harze mit einem Anteil von 0 bis 50 Gew.-% oder alternativ von
iii) Epoxidharzen mit Härtern mit einem Anteil von 0 bis 40 Gew.-%.

Aus der JP 06 187 834 ist eine Klebemasse bekannt, in der Partikel vorhanden sind, die eine Leitfähigkeit durch die Klebemasse sicherstellen.

Die Partikel stellen eine Mischung aus kleinen, metallbeschichteten Kunststoff-Partikeln und größeren Metallpartikeln geringerer Härte dar. Beide Arten der Partikel sind formbar, insbesondere die größeren Metallpartikel.

Der Erfindung liegt die Aufgabe zugrunde, bei einer Verklebung eines Trägerelements in Datenträgem oder elektronischen Bauteilen mit Hilfe einer thermoaktivierbaren Klebeschicht eine gute und dauerhafte Verbindung zu erzielen bei gleichzeitiger Herstellung eines elektrisch leitfähigen Kontaktes.

Gelöst wird diese Aufgabe durch eine Klebstoffolie, wie sie in dem Hauptanspruch näher gekennzeichnet ist. Gegenstand der Unteransprüche sind vorteilhafte Weiterbildungen des Erfindungsgegenstands.

Erfindungsgemäß enthält die elektrisch leitfähige, thermoplastische und hitzeaktivierbare Klebstoffolie
i) ein thermoplastisches Polymer mit einem Anteil von zumindest 30 Gew.-%,
ii) ein oder mehrere klebrigmachende Harze mit einem Anteil von 5 bis 50 Gew.-% und/oder
iii) Epoxidharze mit Härtern, gegebenenfalls auch Beschleunigern, mit einem Anteil von 5 bis 40 Gew.-%,
iv) metallisierte Partikel mit einem Anteil von 0,1 bis 40 Gew.-%, besonders bevorzugt 10 Gew.-%,
v) nur schwer oder nicht verformbare Spacerpartikel mit einem Anteil von 1 bis 10 Gew-%, die bei der Verklebungstemperatur der Klebstoffolie nicht schmelzen.

Vorzugsweise weist die Klebstoffolie eine Dicke von 10 bis 500 µm auf.

Die Klebstoffolie ist eine Mischung von reaktiven Harzen, die bei Raumtemperatur vernetzen und ein dreidimensionales, hochfestes Polymernetzwerk bilden, und von dauerelastischen Elastomeren, die einer Versprödung des Produktes entgegenwirken und somit dauerhafte Belastungen (Stauchungen, Dehnungen) des Produktes ermöglichen.

Das Elastomer stammt bevorzugt aus der Gruppe der Polyolefine, Polyester, Polyurethane oder Polyamide oder kann ein modifizierter Kautschuk sein wie zum Beispiel Nitrilkautschuk oder auch Polyvinylbutyral, Polyvinylformal, Polyvinylacetat, carboxyliertes oder epoxyliertes SEBS-Polymer.

Durch die chemische Vemetzungsreaktion (auf Basis von Epoxiden oder Phenolharzkondensation) der Harze bei erhöhter Temperatur werden große Festigkeiten zwischen dem Klebefilm und der zu verklebenden Oberfläche erzielt und eine hohe innere Festigkeit des Produktes erreicht.

Die Zugabe der reaktiven Harz/Härtersystemen führt auch zu einer Erniedrigung der Erweichungstemperatur der oben genannten Polymere, was ihre Verarbeitungstemperatur und -geschwindigkeit vorteilhaft senkt. Das geeignete Produkt ist ein bei Raumtemperatur oder leicht erhöhten Temperaturen selbsthaftendes Produkt. Beim Erhitzen des Produktes kommt es kurzfristig auch zu einer Erniedrigung der Viskosität wodurch das Produkt auch rauhe Oberflächen benetzen kann.

Durch die geeignete Mischung von Harzen/Härtersystemen und den Polymeren wird eine Eigenschaft erreicht, die es ermöglicht, beim Verkleben unter Druck und Wärme die Dicke der Klebemasseschicht signifikant zu verändern. So kann zum Beispiel mit einem ca. 65 µm dicken Produkt leicht eine ca. 45 µm dicke Klebfuge hergestellt werden.
Die "überschüssige" Klebemasse wird dabei verdrängt, was bei der Konstruktion der Verklebungsgegenstände oder bei der Konfektionierung des Klebers berücksichtigt wird. Bei beispielsweise Chipkarten kann die Klebemasse leicht in die benachbarte Hohlstelle unter dem Modul ausweichen.

Die Zusammensetzungen für die Klebstoffolie lassen sich durch Veränderung von Rohstoffart und -anteil in weitem Rahmen variieren. Ebenso können weitere Produkteigenschaften wie beispielsweise Farbe, thermische oder elektrische Leitfähigkeit durch gezielte Zusätze von Farbstoffen, mineralischen bzw. organischen Füllstoffen, beispielsweise Siliziumdioxid, und/oder Kohlenstoff- bzw. Metallpulvern erzielt werden.

Die in der Klebstoffolie enthaltenen weichen leitfähigen Partikel ermöglichen lediglich eine Leitfähigkeit in z- Richtung; in der x-y-Ebene kommt wegen der fehlenden Berührung untereinander keine Leitfähigkeit zustande. Die Weichheit der Partikel bewirkt, daß sich die Partikel an den Berührungsflächen zu den Substraten abflachen, was die Kontaktfläche erhöht und sich an mechanische Belastung anpassen können.

Zu harte elektrisch leitfähige Partikel sorgen bei Dehnungen, Stauchungen und Biegungen zur Ablösung des Klebefilms vom Substrat in der Nähe der Partikel und verlieren dann selbst den Kontakt. Besonders vorteilhaft ist deshalb die Verwendung von weichen oder elastischen, sphärischen, metallisierten Partikeln, deren Kern aus Metall oder Kunststoff besteht und die sich an die Dicke der Klebemasseschicht nach der Verpressung anpassen können, da der Kern sich bei den Verklebungstemperaturen verformen läßt. Diese Partikel können Metallkugeln - zum Beispiel aus Gold, Nickel Silber -, versilberte Metallkugeln oder vorzugsweise metallisierte beziehungsweise metallbeschichtete Polymer- oder Elastomerkugeln - wie Kunststoffkugeln, Styroporkugeln - sein, wobei die Beschichtung mit einem gut leitfähigem Metall (Gold, Silber, Kupfer, Nickel) erfolgt. Des weiteren können die Metall- oder Kunststoffkugeln mit leitfähigem Polymer beschichtet sein.

Vorzugsweise liegt der Durchmesser der metallisierten Partikel unter der Dicke der Klebemasseschicht, und sind die Partikel härter als die Klebemasse bei der Verklebungstemperatur (> 60 °C).

Um leichtes Anheften (keine herausragenden Partikel) und vollflächige Verklebung ohne Lufteinschlüsse zu ermöglichen, sind die leitfähigen Partikel kleiner als die Klebemasseschicht gewählt. Um jedoch eine Leitfähigkeit in z-Richtung herzustellen, ist somit ein Pressdruck bei erhöhter Temperatur und eine bestimmte Viskosität der Klebemasse bei dieser Temperatur nötig, um die Klebemasse zu verdrängen und einen Kontakt zwischen leitfähigen Partikeln und Substratoberflächen zu ermöglichen.

Das Problem, das sich stellt ist, daß beim Verpressen zuviel Klebemasse ausgedrückt wird, die Klebemasseschicht zu dünn und die leitfähigen Partikel zudem geschädigt würden. Eine Lösung dieses Konflikts besteht in der zusätzlichen Verwendung von beigemischten Spacerpartikel. Sie sorgen für eine genaue Fugendicke bei der Verklebung und schützen die weichen Partikel vor zu großer Verpressung, was zum Beispiel bei metallisierten Polymerpartikel zu einer Zerstörung der Metallschicht führen würde.

Um eine zu starke Deformation der Klebstoffolie zu verhindern, ist es notwendig, Spacerpartikel beizumischen, und zwar zu einem Anteil von 1-10 Gew.-% (bei einer vorausgesetzten mittleren Verklebungsfläche im Bereich von ca. 1 cm²). Die Spacerpartikel sind von sphärischer Geometrie und bestehen aus einem harten Material, das bei der erhöhten Verklebungstemperatur nicht schmilzt und nur schwer oder nicht verformbar ist. Die Spacerpartikel können ebenfalls leitfähig sein, sie sollten jedoch härter sein als die metallisierten Partikel. Des weiteren sollten sie einen kleineren Durchmesser als die leitfähigen Partikel haben.

Die Dicke der Spacerpartikel entspricht etwa der nach der Verpressung beziehungsweise Verklebung gewünschten Dicke der Klebmasseschicht. Sie weisen somit einen Durchmesser auf, der geringfügig kleiner ist als die Dicke der Klebstoffolie. Sie ermöglichen eine genaue Einstellung dieser Dicke durch den Verklebungsprozess unter Temperatur, Druck und die Planparallelität der Druckstempel, auch wenn diese Verklebungsparameter schwanken. Die erwähnten Spacer sind dabei vorzugsweise sphärische harte Partikel wie zum Beispiel Glaskugeln. Eine Metallschicht auf diesen Kugeln ist möglich, jedoch nicht notwendig, weil die weichen metallisierte Partikel genügend Leitfähigkeit bewirken und somit bereits ein leitfähiges System vorhanden ist.

Besonders vorteilhaft kann die erfindungsgemäße Klebstoffolie eingesetzt werden zum Implantieren von elektrischen Modulen in einen Kartenkörper, der mit einer Aussparung versehen ist, in die ein elektronisches Modul anzuordnen ist, das auf der ersten Seite mehrere Kontaktflächen und auf der der ersten Seite gegenüberliegenden zweiten Seite einen IC-Baustein aufweist, dessen Anschlußpunkte über elektrische Leiter mit den Kontaktflächen verbunden sind, wobei die Klebstoffolie zur Verbindung der zweiten Seite des Moduls mit dem Kartenkörper dient.
Durch die reproduzierbare Klebfugendicke schließt das eingesetzte Modul immer bündig mit Chipkartenoberfläche ab und steht nicht hervor. Daneben wird durch den elektrisch leitfähigen Klebefilm ein elektrisch leitfähiger Kontakt zwischen dem Modul und zum Beispiel einer Antenne in dem Kartenkörper erzeugt ohne einen Kurzschluß zu bewirken.

Vorzugsweise hat in diesem Falle die Klebstoffolie die gleichen Maße wie das Modul und liegt als Stanzling vor.

Darüber hinaus ist auch die Verwendung der Klebstoffolie zum strukturellen Kleben möglich, gegebenenfalls mit anschließender Hitzehärtung.

Zur Herstellung der Klebstoffolie wird die Folie bildende Masse als Lösung auf ein flexibles Substrat (Trennfolie oder Trennpapier) gegossen und getrocknet, so daß die Masse von dem Substrat leicht wieder entfernt werden kann.

Nach entsprechender Konfektionierung können Stanzlinge oder Rolle von dieser Klebstoffolie bei Raumtemperatur oder bei leicht erhöhter Temperatur auf das zu verklebende Substrat (elektronisches Bauteil, Modul etc.) aufgeklebt werden.

Die zugemischten reaktiven Harze sollten bei der leicht erhöhten Temperatur noch keine chemische Reaktion eingehen. So muß die Verklebung nicht als einstufiges Verfahren erfolgen, sondern auf eines der beiden Substrate kann einfachheitshalber, wie bei einem Haftklebeband, zunächst die Klebstoffolie geheftet werden, indem man in der Wärme laminiert. Beim eigentlichen Heißklebeprozess mit dem zweiten Substrat härtet das Harz dann ganz oder teilweise aus und die Klebefuge erreicht die hohe Verklebungsfestigkeit, weit oberhalb denen von Haftklebesystemen.
Die Klebstoffolie ist dementsprechend insbesondere für ein Heißverpressen bei Temperaturen über 60 °C, insbesondere bei 120 bis 200 °C, geeignet.

Anders als leitfähig gefüllte Flüssigkleber oder Klebepasten, die meist zur isotrop leitfähigen Verbindung geeignet sind, härtet die beschriebene Klebstoffolie aber nicht zu einem spröden Film aus, sondern bleibt durch das ausgewogene Verhältnis von Vernetzerharz und elastischen Kautschuk in einem zähelastischen Zustand, wodurch insbesondere Schälbewegungen und - Beanspruchungen gut überstanden werden könnten. Der große Vorteil des beschriebenen Klebefilms kommt überall dort zum Tragen, wo bisher eine Verklebung oder Befestigung und eine elektrisch leitende Verbindung in zwei separaten Schritten durchgeführt wurde. Das bedeutet in den allermeisten Fällen auch ein erhöhter Platzbedarf für Befestigung und leitfähiger Verknüpfung, was bei kleineren elektronischen Bauteilen von Nachteil ist. Auch benötigt der separat durchgeführte Verklebungsschritt eine spezielles und teures Equipment.

Die Erfindung beschreibt eine elektrisch leitfähige, thermoplastische und hitzeaktivierbare Klebstoffolie, wie sie zur dauerhaften Verbindung von zwei Gegenständen verwendet wird. Im Gegensatz zu Verklebungen mit einem Haftklebeband werden hierbei Festigkeiten, wie sie im konstruktiven Bereich benötigt werden, dauerhaft erreicht und auch bei chemischen, thermischen oder klimatischen Belastungen beibehalten.

Die Erfindung beschreibt ein Produkt, das
- hohe Festigkeiten erreicht,
- sich an Dehnungen und Stauchungen der Klebefuge anpassen kann, ohne sich abzulösen,
- Partikel enthält, die die elektrisch Leitfähigkeit bewirken, die sich ebenfalls an diese mechanischen Belastungen anpassen können, ohne den Kontakt zu verlieren,
- leicht durch wenig Wärme angeheftet werden kann, da keine Partikel aus der Klebemasse ragen, die zu Lufteinschlüssen führen würden,
- nach einer Verklebung unter Druck eine leitfähige Verbindung ohne Lufteinschlüsse ergibt; (dies ist wichtig, da auch durch höheren Anpressdruck sich die eingeschlossenen Luftblasen, die vor allem im Lichtmikroskop um die versilberten Partikel herum zu beobachten sind, nicht mehr auspressen lassen ),
- durch zugemischte Spacerpartikel auch bei schwankenden Verarbeitungsparametem (Druck, Temperatur, Planparallelität der Werkzeuge) immer eine gleichmäßige und gleichdicke Klebefuge ergibt.

Die erfindungsgemäßen Klebstoffolien zeichnen sich somit durch eine Reihe von Vorteilen aus:
- Sie besitzen eine hohe Kohäsion und Elastizität bei Raumtemperatur.
- Sie zeigen eine hohe Adhäsion auf den üblichen Chip-Kartenmaterialien wie beispielsweise PVC, PC, PET oder ABS.
- Sie sind aktivierbar unterhalb der Erweichungstemperatur der Kartenmaterialien.
- Sie lassen sich bei geeigneter Verarbeitungstemperatur und -druck zusammenpressen, wodurch die Schichtdicke der Verklebung unterhalb der Schichtdicke der eingesetzten Klebefolie liegt.
- Sie stellen eine elektrische Leitfähigkeit durch beigemischte Partikel her, die weich sind jedoch von größerer Härte als die Klebemasse bei der Verklebungstemperatur.
- Sie enthalten zusätzlich Spacer-Partikel, die die minimale Schichtdicke der Klebemassefuge festlegen, um die leitfähigen Partikel nicht zu stark zu deformieren und zu beschädigen.
- Sie können auf herkömmlichen Verarbeitungsmaschinen zur Herstellung von Smart Cards, wie sie von den Firmen Mühlbauer oder Ruhlamat angeboten werden, verarbeitet werden.

Darüber hinaus weisen Chipkarten, deren Module mit einer erfindungsgemäßen Klebstoffolie eingeklebt werden, eine besonders hohe Biegefestigkeit auf. Dies beweist die Durchführung eines Dauerbiegetests unter ständigem Lastwechsel nach DIN EN 20 178 mit anschließender Funktionsprüfung.

Im folgenden soll anhand eines Beispiels die erfindungsgemäße Klebstoffolie verdeutlicht werden, ohne die beschriebene Erfindung unnötig einschränken zu wollen.

### Beispiel 1

Eine übliche Klebfolienrezeptur in 30iger Lösung in einem Gemisch von Ketonen wird mit folgenden Leitfähigkeits- und Spacer-Partikel versetzt und als Klebstoffilm auf Trennpapier getrocknet.
Die Klebfolienrezeptur weist die folgende Zusammensetzung auf:

| | Gew.-% |
|---|---|
| Nitrilkautschuk | 52 |
| Phenolharz | 30 |
| Glaskugeln | 10 |
| Goldbeschichtete Polystyrolkugeln | 8 |

| | | |
|---|---|---|
| Dicke der getrockneten Klebstoffolie | µm 60 | ASTM D 1000 |
| Gewicht des Klebstoffolie | g/m² 58 | ASTM D 1000 |

Durch eine kurzzeitige Verklebung bei 190 °C, 1 sec, Druck: 60 N/cm² wird die Folie zu einer Klebefuge von 45 µm verpresst und zeigt folgende Testergebnisse:

| | | |
|---|---|---|
| Durchgangswiderstand | mΩ 3,5 | ASTM D 2739 |
| spez. Widerstand | Ωm 0,30 | ASTM D 2739 |
| Verklebungsfestigkeit | N/mm² 9,0 | DIN EN 1465 |

## Patentansprüche

1. Elektrisch leitfähige, thermoplastische und hitzeaktivierbare Klebstoffolie, enthaltend
i) ein thermoplastisches Polymer mit einem Anteil von zumindest 30 Gew.-%,
ii) ein oder mehrere klebrigmachende Harze mit einem Anteil von 5 bis 50 Gew.-% und/oder
iii) Epoxidharze mit Härtern, gegebenenfalls auch Beschleunigern, mit einem Anteil von 5 bis 40 Gew.-%,
iv) metallisierte Partikel mit einem Anteil von 0,1 bis 40 Gew.-%,
v) nur schwer oder nicht verformbare Spacerpartikel mit einem Anteil von 1 bis 10 Gew-%, die bei der Verklebungstemperatur der Klebstoffolie nicht schmelzen.

2. Klebstoffolie nach Anspruch 1, **dadurch gekennzeichnet, daß** es sich beim thermoplastischen Polymer um thermoplastisches Polyolefine, Polyester, Polyurethane oder Polyamide oder modifizierte Kautschuke, wie insbesondere Nitrilkautschuke, handeln.

3. Klebstoffolie nach Anspruch 1, **dadurch gekennzeichnet, daß** die Klebstoffolie mit einem oder mehreren Additiven wie Farbstoffen, mineralischen bzw. organischen Füllstoffen, beispielsweise Siliziumdioxid, Kohlenstoffpulvern und Metallpulvern abgemischt ist.

4. Thermoplastische Klebstoffolie nach Anspruch 1, **dadurch gekennzeichnet, daß** die Klebstoffolie eine Dicke von 10 bis 500 µm aufweist

5. Thermoplastische Klebstoffolie nach Anspruch 1, **dadurch gekennzeichnet, daß** die leitfähigen Partikel metallisierte oder mit leitfähigem Polymer beschichtete Metall- oder Kunstsoffkugeln sind.

6. Thermoplastische Klebstoffolie nach Anspruch 1, **dadurch gekennzeichnet, daß** die leitfähigen Partikel einen größeren Durchmesser als die Spacerpartikel haben.

7. Thermoplastische Klebstoffolie nach Anspruch 1, **dadurch gekennzeichnet, daß** die Spacerpartikel härter sind als die leitfähigen Partikel.

8. Thermoplastische Klebstoffolie nach Anspruch 1, **dadurch gekennzeichnet, daß** die Klebstoffolie für ein Heißverpressen bei Temperaturen über 60°C, insbesondere bei 100 bis 220 °C, geeignet ist.

9. Thermoplastische Klebstoffolie nach Anspruch 1, **dadurch gekennzeichnet, daß** die Klebstoffolie die gleichen Maße wie das Modul hat und als Stanzling vorliegt.

10. Thermoplastische Klebstoffolie nach Anspruch 1, **dadurch gekennzeichnet, daß** die Spacerpartikel einen Durchmesser aufweisen, der geringfügig kleiner ist als die Dicke der Klebstoffolie.

11. Thermoplastische Klebstoffolie nach Anspruch 1, **dadurch gekennzeichnet, daß** die Spacerpartikel von sphärischer Geometrie sind.

12. Verwendung einer Klebstoffolie nach einem der Ansprüche 1 bis 11 zum Implantieren von elektrischen Modulen in einen Kartenkörper, der mit einer Aussparung versehen ist, in die ein elektronisches Modul anzuordnen ist, das auf der ersten Seite mehrere Kontaktflächen und auf der der ersten Seite gegenüberliegenden zweiten Seite einen IC-Baustein aufweist, dessen Anschlußpunkte über elektrische Leiter mit den Kontaktflächen verbunden sind, wobei die Klebstoffolie zur Verbindung der zweiten Seite des Moduls mit dem Kartenkörper dient.

13. Verwendung einer Klebstoffolie nach einem der Ansprüche 1 bis 11 zum strukturellen Kleben, gegebenenfalls mit anschließender Hitzehärtung.

## Claims

1. Electrically conductive, thermoplastic and heat-activatable adhesive sheet comprising
i) a thermoplastic polymer in a proportion of at least 30% by weight,
ii) one or more tackifying resins in a proportion of from 5 to 50% by weight and/or
iii) epoxy resins with hardeners, with or without accelerators, in a proportion of from 5 to 40% by weight,
iv) metallized particles in a proportion of from 0.1 to 40% by weight,
v) non-deformable or virtually non-deformable spacer particles, in a proportion of from 1 to 10% by weight, which do not melt at the bonding temperature of the adhesive sheet.

2. Adhesive sheet according to Claim 1, **characterized in that** the thermoplastic polymer comprises thermoplastic polyolefins, polyesters, polyurethanes or polyamides or modified rubbers, such as, in particular, nitrile rubbers.

3. Adhesive sheet according to Claim 1, **characterized in that** the adhesive sheet has been blended with one or more additives such as colourants, mineral and/or organic fillers, for example silica, carbon powders and metal powders.

4. Thermoplastic adhesive sheet according to Claim 1, **characterized in that** it has a thickness of from 10 to 500 µm.

5. Thermoplastic adhesive sheet according to Claim 1, **characterized in that** the conductive particles are metallized or conductive-polymer-coated metal or plastic beads.

6. Thermoplastic adhesive sheet according to Claim 1, **characterized in that** the conductive particles have a greater diameter than the spacer particles.

7. Thermoplastic adhesive sheet according to Claim 1, **characterized in that** the spacer particles are harder than the conductive particles.

8. Thermoplastic adhesive sheet according to Claim 1, **characterized in that** it is suitable for hot pressing at temperatures above 60°C, in particular from 100 to 220°C.

9. Thermoplastic adhesive sheet according to Claim 1, **characterized in that** it has the same dimensions as the module and is in the form of a punched section.

10. Thermoplastic adhesive sheet according to Claim 1, **characterized in that** the diameter of the spacer particles is slightly smaller than the thickness of the adhesive tape.

11. Thermoplastic adhesive sheet according to Claim 1, **characterized in that** the spacer particles are of spherical geometry.

12. Use of an adhesive sheet according to one of Claims 1 to 11 for implanting electrical modules into a card body which is provided with a recess which is intended to accommodate an electronic module which has on its first side a plurality of contact faces and on its second side, which is opposite to the first side, an IC chip whose terminals are connected via electrical conductors to the contact faces, the adhesive sheet being used to connect the second side of the module to the card body.

13. Use of an adhesive sheet according to one of Claims 1 to 11 for structural bonding, with or without subsequent heat curing.

## Revendications

1. Feuille adhésive électriquement conductrice, thermoplastique et à activation thermique, contenant:
i) un polymère thermoplastique à raison d'une fraction d'au moins 30% en poids,
ii) une ou plusieurs résines adhérisantes à raison d'une fraction de 5 à 50% en poids et/ou
iii) des résines époxy avec durcisseurs, éventuellement aussi des accélérateurs, à raison d'une fraction de 5 à 40% en poids,
iv) des particules métallisées à raison de 0,1 à 40% en poids,
v) des particules d'espacement peu ou pas déformables, à raison de 1 à 10% en poids, ne fondant pas à la température de collage de la feuille adhésive.

2. Feuille adhésive selon la revendication 1, **caractérisée en ce que** le polymère thermoplastique est une polyoléfine thermoplastique, un polyester, un polyuréthanne ou un polyamide, ou des caoutchoucs modifiés, comme en particulier des caoutchoucs nitrile.

3. Feuille adhésive selon la revendication 1, **caractérisée en ce que** la feuille adhésive est mélangée à un ou plusieurs additifs, comme des colorants, des charges minérales ou organiques, par exemple du dioxyde de silicium, des poudres de carbone et des poudres métalliques.

4. Feuille adhésive thermoplastique selon la revendication 1, **caractérisée en ce que** la feuille adhésive présente une épaisseur de 10 à 500 µm.

5. Feuille adhésive thermoplastique selon la revendication 1, **caractérisée en ce que** les particules conductrices sont des billes de métal ou de plastique métallisées ou revêtues d'un polymère conducteur.

6. Feuille adhésive thermoplastique selon la revendication 1, **caractérisée en ce que** les particules conductrices ont un diamètre supérieur à celui des particules d'espacement.

7. Feuille adhésive thermoplastique selon la revendication 1, **caractérisée en ce que** les particules d'espacement sont plus dures que les particules conductrices.

8. Feuille adhésive thermoplastique selon la revendication 1, **caractérisée en ce que** la feuille adhésive convient pour un pressage à chaud à des températures de plus de 60°C, en particulier de 100 à 220°C.

9. Feuille adhésive thermoplastique selon la revendication 1, **caractérisée en ce que** la feuille adhésive a les mêmes dimensions que le module et se présente comme une pièce estampée.

10. Feuille adhésive thermoplastique selon la revendication 1, **caractérisée en ce que** les particules d'espacement ont un diamètre légèrement inférieur à l'épaisseur de la feuille adhésive.

11. Feuille adhésive thermoplastique selon la revendication 1, **caractérisée en ce que** les particules d'espacement sont de géométrie sphérique.

12. Utilisation d'une feuille adhésive selon l'une quelconque des revendications 1 à 11 pour l'implantation de modules électriques dans un corps de carte, lequel est pourvu d'une découpe dans laquelle est à placer un module électronique, qui présente sur le premier côté plusieurs surfaces de contact et, sur le deuxième côté opposé au premier côté, un élément à circuit intégré (IC), dont les points de raccordement sont reliés aux surfaces de contact par des conducteurs électriques, la feuille adhésive servant à la liaison du deuxième côté du module avec le corps de la carte.

13. Utilisation d'une feuille adhésive selon l'une quelconque des revendications 1 à 11 pour des collages structurels, éventuellement avec durcissement thermique subséquent.
